Europäisches Patentamt

European Patent Office

Office européen des brevets

(11) Publication number: **0 082 325**

**B1**

# (12) EUROPEAN PATENT SPECIFICATION

(45) Date of publication of patent specification: 26.10.88

(51) Int. Cl.⁴: **H 01 L 21/28, H 01 L 21/203**

(21) Application number: **82110783.6**

(22) Date of filing: **22.11.82**

(54) Semiconductor device comprising a metallic conductor.

(30) Priority: **27.11.81 JP 189350/81**

(43) Date of publication of application:
**29.06.83 Bulletin 83/26**

(45) Publication of the grant of the patent:
**26.10.88 Bulletin 88/43**

(84) Designated Contracting States:
**DE FR GB NL**

(56) References cited:
**US-A-3 929 527**
**US-A-4 169 746**

**JAPANESE JOURNAL OF APPLIED PHYSICS,
vol. 20, 1981, suppl. 20-1, Proceedings of the
12th conference on solid state devices, pages
49-54, Tokyo, JP; S. SAITOH et al.: "Formation
of a double-hetero Si/CoSi2/Si structure using
molecular beam and solid phase epitaxies"**

**JAPANESE JOURNAL OF APPLIED PHYSICS,
vol. 10, no. 1, January 1971, pages 45-51,
Tokyo, JP; Y. YASUDA: "Epitaxial growth of
silicon films on sapphire and spinel by vacuum
evaporation"**

(73) Proprietor: **Hitachi, Ltd.**
**5-1, Marunouchi 1-chome**
**Chiyoda-ku Tokyo 100 (JP)**

(72) Inventor: **Nakagawa, Kiyokazu**
**4-14-6, Nishi-koigakubo**
**Kokubunji-shi Tokyo (JP)**
Inventor: **Murayama, Yoshimasa**
**4-2-1-320, Maehara-cho**
**Koganei-shi Tokyo (JP)**
Inventor: **Shiraki, Yasuhiro**
**3-26-1-1-106, Hirayama**
**Hino-shi Tokyo (JP)**

(74) Representative: **Strehl, Peter, Dipl.-Ing. et al
Strehl, Schübel-Hopf, Schulz Patentanwälte
Widenmayerstrasse 17 Postfach 22 03 45
D-8000 München 22 (DE)**

Courier Press, Leamington Spa, England.

## Description

### Background of the invention
### Field of the invention

This invention relates to a semiconductor device of the type set forth in the first part of claim 1.

In forming such vertical semiconductor devices such as diodes, bipolar transistors, FETs (Field Effect Transistors) and the like, one of the electrodes of each device is inevitably interposed between a semiconductor and a substrate.

### Description of the prior art

SOS (Silicon-On-Sapphire) has been known conventionally as a technique of heteroepitaxially growing a semiconductor film on an insulating substrate and forming a semiconductor device in the film. In SOS, however, the device is limited to the lateral type because no metallic film is interposed between Si and sapphire. Since the lateral type semiconductor device uses photolithography (or electron lithography) to determine the shape and size of the active region, a device length of 0.5 μm is believed a practical limit. Accordingly, the performance that can be expected of such a relatively large device is naturally limited as typified by the switching time of at least 50 ps in the case of Si, for example. In the lateral devices of GaAs, an HEMT (High Electron Mobility Transistor) skilfully employing the heterostructure has been known but the limit of the switching time is believed to be 30 ps at room temperature because machining below 0.5 μm is extremely difficult.

The idea of interposing a metallic film between a semiconductor film and an insulating substrate to form an electrode has been known in the past, but such an idea is limited to those devices which are fabricated inside polycrystalline semiconductor films superposed on a polycrystalline metal layer and are limited to those generally referred to as "TFTs" (thin film transistors). These devices involve the drawbacks resulting from the polycrystalline film that the switching speed is low, the leakage current is great and the period of time for the recombination of the minority carriers is short.

Incidentally, the above-mentioned SOSs and TFTs are disclosed in the following literatures:

(1) Proc. IEEE. 52, p. 1487 ('64), C. W. Mueller et al, "Grown-film silicon transistors on sapphire",

(2) Proc. IEEE, 52, p. 1479 ('64), P. K. Weimer et al, "Integrated circuits incorporating thin-film active and passive elements".

Typical examples of the heterostructures grown by molecular beam epitaxy of silicon and metal silicide are disclosed in the following literatures:

(3) Appl. Phys. Lett., 37. p. 643 ('80), J. C. Bean and J. M. Poate "Silicon/metal silicide heterostructures grown by molecular beam epitaxy".

(4) Appl. Phys. Lett., 23, p. 201 ('73), "Molecular beam epitaxy of alternating metal-semiconductor films".

The semiconductor device according to the first part of claim 1 is known from US—A—4 169 749. There, electrodes are disposed upon a sapphire substrate, and silicon layers including active regions overlap the electrodes. The material of the electrodes, however, it tungsten or molybdenum, on which silicon can grow only in polycrystalline form. For this reason, the active region cannot be disposed immediately above or in close vicinity to the electrodes. This again results in low integration density, long wirings, large wiring capacity and limited speed.

### Summary of the invention

It is an object of the present invention to provide a vertical semiconductor device of high speed, low leakage current and high integration density.

This object is met by the invention as defined in claim 1. Due to the use of a silicide of a transition metal for the electrode layer, the silicon region can grow hetero-epitaxially and thus in monocrystalline form. The active region of the semiconductor device may therefore be disposed immediately upon the electrode so that the disadvantages mentioned above are avoided.

Molecular beam epitaxy may be used for the hetero-epitaxial growth. Typical examples of the insulating substrate include sapphire and spinel. The metallic-conduction material layer is generally from about 20 nm to about 3 μm thick. The lower limit of the thickness is that which permits electrical wiring, while the upper limit depends on factors other than the electric conduction. Much advantage is not obtained, however, by making the layer very thick.

Definite examples of the silicides of transitions metals will be illustrated in the later appearing examples.

It is possible to interpose a so-called "buffer layer" between the electrode layer and the semiconductor layer having active region in order to improve their lattice matching.

### Brief description of the drawings

Figure 1 is a perspective view showing a Schottky gate FET to which the present invention is applied;

Figures 2a to 2d and 3 are sectional views, each showing stepwise the fabrication step of the transistor shown in Figure 1;

Figure 4 is a sectional view of an integrated diode;

Figure 5 is a sectional view of a bipolar transistor;

Figure 6 is a sectional view of a switching device;

Figure 7 is a sectional view of a vertical type junction FET; and

Figure 8 is a sectional view of a lateral type junction FET.

### Description of the preferred embodiments

A variety of semiconductor devices can be naturally fabricated using the semiconductor material described already. Examples of the semiconductor devices are as follows:

bipolar transistor including a pnp (or npn) or pinp (or nipn) structure in the semiconductor material;

diode including a pin or pnin (or npin) structure in the semiconductor material;

switching device having a pnpn structure;

static induction transistor (SIT);

junction field effect transistor (J-FET);

Schottky barrier gate—SIT;

permeable base transistor (PBT).

Various other semiconductor devices can also be fabricated.

In addition to the high speed performance resulting from the small wiring capacity, the semiconductor device in accordance with the present invention can improve by far the performance over the lateral devices because the active region is determined by the thickness of the semiconductor film formed by heteroepitaxial growth.

Example 1

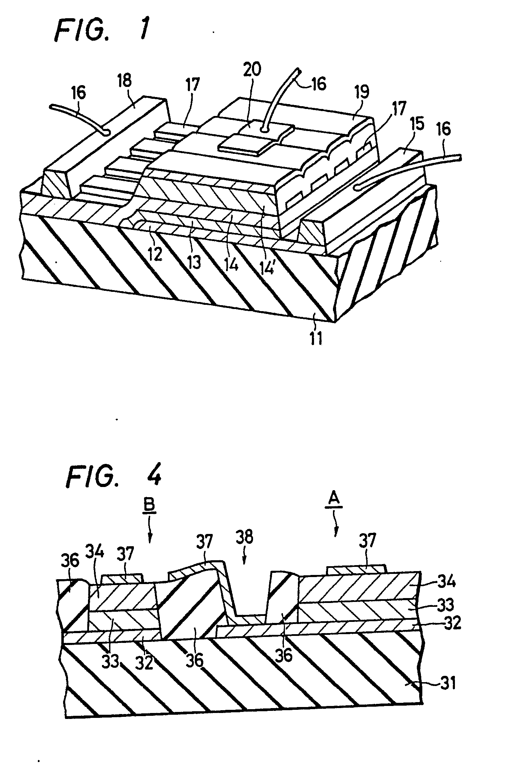

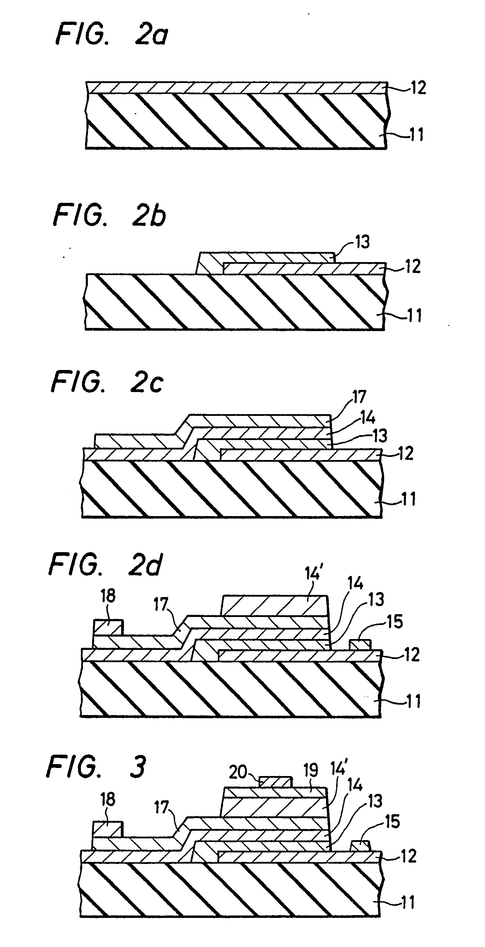

This example uses sapphire as the insulating substrate. Figure 1 is a perspective view of a vertical Schottky gate FET and Figures 2a through 2e are sectional views, showing stepwise the fabrication process of the FET.

As shown in Figure 2a, sapphire is used as the insulating substrate 11 and Si and Ni are simultaneously vacuum-evaporated for epitaxial growth in a thickness of 20 nm in such a ratio that an intermetallic compound 12 of $NiSi_2$ is formed. The vacuum in this case is generally $1,33\times10^{-7}$ Pa (at least $1,33\times10^{-6}$ Pa). The temperature of the substrate is from about 550°C to about 800°C and the growing speed is about 0.1 nm/s. The layer 12 is then shaped photolithographically in the customary manner so that discrete devices can be electrically cut off. Silicon and antimony are then vacuum-evaporated simultaneously and an n-type Si layer 13 having a carrier concentration of $1\times10^{18}$ cm$^{-3}$ is heteroepitaxially grown in a thickness of 10 nm. The n-type Si layer 13 is made into a predetermined shape. At the substrate temperature ranging from 500 to 700°C, an extremely small trace amount of Sb is doped and an Si vacuum-evaporation layer 14 having relatively high resistivity is heteroepitaxially grown in a thickness of 50 nm. Its carrier concentration is selected in the range of

$$10^{14}\leqq n\leqq 3\times10^{16} cm^{-3}.$$

The Si layers 13 and 14 are photo-etched in predetermined patterns so as to partially expose the layer 12. An $NiSi_2$ film 17 is grown further thereon in a thickness of 20 nm and is made into a lattice having a width of 1 μm and a gap of 1 μm by photolithography (Fig. 2c; refer to Figure 1 for the lattice portion of the layer 17).

Next, polycrystalline Al layers 15, 18 are vacuum-evaporated and made photolithographically in predetermined shapes so as to transversely connect the lattices. The same Si having relatively high resistivity as the layer 14 is heteroepitaxially grown (14') in a thickness of 50 nm so as to define a structure so that Si encompasses the aforementioned lattice (see Figure 2d). The same Si:Sb film 19 as the layer 13 is grown heteroepitaxially over the entire surface of the structure in a thickness of 20 nm, such as depicted in Figure 1. An aperture reaching the aluminum film 15 is bored in the layers 19 and 14' by photolithography and Al thus exposed and an external electrode are wire-bonded. An electrode 20 is simultaneously disposed (16). Thus, the vertical Schottky gate FET having the structure shown in Figure 3 is obtained. The regions 13 and 19 correspond to means for injecting and sucking the carriers such as the source and drain in ordinary FETs and the electrode 17 corresponds to carrier control means such as the gate of the ordinary FET. Reference numerals 15 and 18 represent extension electrodes. Since the length of the active area is as short as 100 nm in the structure of this example, it is confirmed that switching is effected within a period as short as 1/5 to 1/10 of the switching time of the ordinary lateral devices.

Example 2

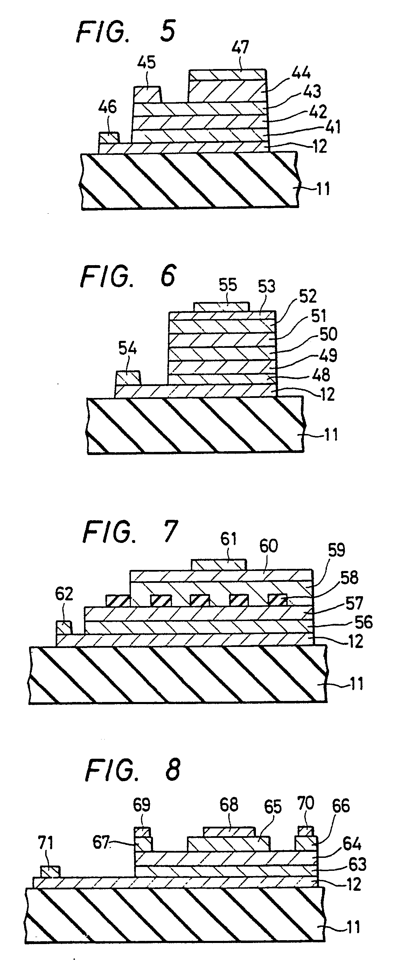

This example illustrates an example of a vertical diode IC. Figure 4 is a sectional view of the device.

$CoSi_2$ 32 is heteroepitaxially grown in a thickness of 30 nm on a spinel substrate 31 at a substrate temperature of 600 to 650°C and photoetching is then carried out to obtain a desired pattern. A 100 nm thick n-type Si 33 doped with As of $2\times10^{17}$ cm$^{-3}$ is heteroepitaxially grown on the pattern.

Next, Ga and Si are simultaneously vacuum-evaporated at the substrate temperature of 500 to 700°C and a p-type Si film 34 is heteroepitaxially grown in a thickness of 100 nm, thereby forming a p-n junction. Next, portions other than the portion at which the diode is electrically isolated are covered with $Si_3N_4$ by a plasma CVD process and selective oxidation is effected at 1,200°C, forming an $SiO_2$ layer 36. In this case, the lower electrode 32 is not oxidized and keeps metallic conduction. An aperture reaching the $CoSi_2$ layer 32 is bored in the necessary region (e.g. region 38) of the resulting $SiO_2$ by photolithography and Al (37) deposited on $SiO_2$ by vacuum evaporation is connected to the layer 32. After photoetching in a predetermined wiring pattern is effected, a vertical diode IC in which a plurality of diodes are integrated can be obtained. In the example shown in Figure 4, the regions A and B from the diodes, respectively.

As the metals forming the heteroepitaxial structure in the semiconductor, the foregoing embodi-ments use Al versus GaAs and $NiSi_2$, and $CoSi_2$ versus Si, but it is also possible to use various combinations such as listed below:

For Si:

$A_xSi$ (where A is a member selected from the group consisting of Ti, Zr, Hf, Cr, Mo, W,

V, Nb, Ta, Mn, Fe, Co, Ni, Pt, Pd, Rh and Ir and x is 0.5, 1, 1.5, 2, 2.5 and 3, for example).

Example 3

The gist of the invention resides in that a laminar material having metallic conduction is heteroepitaxially grown on an insulating substrate, is shaped in a desired pattern, whenever necessary, and is further grown heteroepitaxially to fabricate a semiconductor layer in which a semiconductor device is to be fabricated, and the metallic material is used as one of the electrodes of the device. Various semiconductor devices can be naturally formed thereon. The foregoing embodiments are not limitative. For example, a bipolar transistor, a diode and a switching device can be formed by forming the semiconductor in the pnp (or npn) or pinp (or nipn) structure, in the pin or pnin (or npin) structure and in the pnpn structure, respectively, and the metallic material can be used as one of the electrodes.

Figure 5 through 8 show examples of these other semiconductor devices.

Figure 5 is a sectional view of a typical bipolar transistor.

A metallic material layer 12 consisting of $NiSi_2$ is heteroepitaxially grown on a sapphire substrate 11 by molecular beam epitaxy and a bipolar transistor is formed on the layer thus grown. Reference numerals 41 represents a highly doped n-type Si layer; 42 is an n-type Si layer (about 500 nm thick); 43 is a p-type Si layer (about 50 nm thick); 44 is an n-type Si layer (about 200 nm thick); and 45, 46 and 47 are Al layers. The layers 12, 41, 42, 43 and 44 are heteroepitaxially grown by molecular beam epitaxy in the same way as in the foregoing embodiments. The highly doped n-type Si layer 41 is a layer for the contact with the electrode in the same way as in the ordinary semiconductor device; the layer 42 is a collector, the layer 43 is a base and the layer 44 is an emitter.

Figure 6 is a sectional view showing an example of a switching device having the pnpn structure.

A metallic material layer 12 consisting of $NiSi_2$ is heteroepitaxially grown on a sapphire substrate 11 by molecular beam epitaxy and a switching device is formed thereon. Reference numeral 48 represents a highly doped p-type Si layer for the contact with the metallic material layer 12. Reference numeral 49 represents a p-type Si layer (1 μm thick); 50 is an n-type Si layer (0.5 μm thick); 51 is a p-type Si layer (0.5 μm thick); 52 is an n-type Si layer (1 μm thick); and 53 is a highly doped n-type Si layer for the contact with an electrode 55. These layers are formed by heteroepitaxial growth by molecular beam epitaxy. Reference numerals 55 and 54 represent electrodes consisting of an Al vacuum-evaporation film.

Figure 7 is a sectional view showing an example of a vertical type junction field effect transistor.

A semiconductor film having a pi (or ni) structure is formed and a donor (or acceptor) is selectively introduced into the i layer by ion implantation or vapor/solid phase diffusion to obtain a desired pattern. Alternatively, the i layer is selectively etched and an n (or p) layer is selectively grown on the etched portion to obtain a desired pattern. A gate electrode is thus formed. On the resulting gate electrode, an ip (or in) layer is then grown epitaxially to form a J-FET (junction field effect transistor). The metallic material is used as one of the electrodes of this FET.

An $NiSi_2$ layer 12 is heteroepitaxially grown on a sapphire substrate 11 and the junction field effect transistor is formed on the layer in this embodiment. A comb-like gate 58 consisting of p-type Si is buried in n-type Si layers 57, 59. Though not shown in the sectional view of Figure 7, the gates 58 are connected to one another at one of their ends and form the comb-like shape as a whole. The layers 56 and 60 are layers for establishing contact with the electrodes and are highly doped n-type Si layers. Reference numerals 61 and 62 are source (or drain) and drain (or source) electrodes.

Figure 8 is a sectional view showing an example of a lateral type junction field effect transistor. In the same way as in the foregoing embodiments, the metallic material 12 consisting of $NiSi_2$ is heteroepitaxially grown on the sapphire substrate 11 and the junction field effect transistor is formed on the layer 12. Reference numeral 63 represents a p-type Si layer; 64 is a lowly doped n-type Si layer; 65 is a poly-silicon layer for the gate; 66 and 67 are highly doped n-type Si layers; and 68, 69, 70 and 71 are aluminum electrodes, respectively. The layers 63, 64, 66 and 67 are heteroepitaxially grown by molecular beam epitaxy as described already. The electrode 68 is the gate and a voltage is applied across the electrodes 68 and 71. Reference numerals 69 and 70 represent source (or drain) and drain (or source).

In fabricating the semiconductor devices illustrated in the foregoing embodiments, the following structures can be naturally employed, whenever necessary.

(1) The semiconductor layer grown on the metallic material layer is partially removed and a metallic layer of the same or different kind is laminated at a predetermined position of the metallic layer in a thickness necessary and sufficient for bonding so as to connect an external electrode.

(2) A through-hole is bored at a predetermined position on the semiconductor layer and an insulating film is deposited on the upper surface of the semiconductor layer and on the side surface of the through-hole so that the metallic material layer can be easily connected to the external electrode by a wiring connected to the metallic material layer and disposed on the insulating film.

(3) In forming one semiconductor device and another on the same substrate, either the semiconductor layer is mesa-etched or a portion to be electrically isolated is selectively oxidized or nitrided in order to electrically cut off one device from another.

(4) A metal is deposited at a predetermined position on the semiconductor layer so as to use it as a pad for the bonding connection with an external electrode. Alternatively, an insulating film is deposited on the semiconductor and the film at a predetermined position is removed. A plurality of semiconductor devices on the same substrate are connected to one another by conductor wirings that are brought into contact with the removed portion and are shaped in a desired pattern.

**Claims**

1. A semiconductor device including
an insulating substrate (11),
a layer (12) of a metallic-conduction material deposited on the substrate (11), and
a silicon region (13, 14) grown on said layer (12),
wherein an active region of the semiconductor device is formed in said silicon region (13, 14) and said layer (12) is used as an electrode of the semiconductor device,
characterised in that said layer (12) consists of a silicide of a transition metal which is heteroepitaxially grown on the substrate (11) and on which said silicon region (13, 14) is heteroepitaxially grown.

2. The semiconductor device of claim 1, wherein the substrate (11) consists of sapphire or spinel.

3. The semiconductor device of claim 1 or 2, wherein said silicon region (42...44) has at least a pnp (or npn) structure and forms a bipolar transistor.

4. The semiconductor device of claim 1 or 2, wherein said silicon region has at least a pin or pnin (or npin) structure and forms a diode.

5. The semiconductor device of claim 1 or 2, wherein said silicon region (49...52) has at least a pnpn structure and forms a switching device.

6. The semiconductor device of claim 1 or 2, wherein at least a static induction transistor is formed in said silicon region.

7. The semiconductor device of claim 1 or 2, wherein at least a junction field effect transistor is formed in said silicon region (57...59; 64, 65).

8. The semiconductor device of claim 1 or 2, wherein at least a permeable base transistor is formed in said silicon region.

**Patentansprüche**

1. Halbleitereinrichtung, umfassend
ein isolierendes Substrat (11),
eine auf dem Substrat (11) aufgebrachte Schicht (12) aus einem metallisch leitenden Material, und
einen auf der besagten Schicht (12) gezüchteten Siliciumbereich (13, 14),
wobei in dem Siliciumbereich (13, 14) ein aktiver Bereich der Halbleitereinrichtung ausgebildet ist und die besagte Schicht (12) als Elektrode der Halbleitereinrichtung dient,
dadurch gekennzeichnet, daß die besagte Schicht (12) aus einem Silicid eines Übergangsmetalls besteht, das auf dem Substrat (11) heteroepitaxial gezüchtet ist und auf dem der Siliciumbereich (13, 14) hetero-epitaxial gezüchtet ist.

2. Halbleitereinrichtung nach Anspruch 1, wobei das Substrat (11) aus Saphir oder Spinell besteht.

3. Halbleitereinrichtung nach Anspruch 1 oder 2, wobei der Siliciumbereich (42...44) mindestens einen PNP- (oder NPN-) Aufbau aufweist und einen Bipolartransistor bildet.

4. Halbleitereinrichtung nach Anspruch 1 oder 2, wobei der Siliciumbereich mindestens einen PIN- oder PNIN- (oder NPIN-)Aufbau aufweist und eine Diode bildet.

5. Halbleitereinrichtung nach Anspruch 1 oder 2, wobei der Siliciumbereich (49...52) mindestens einen PNPN-Aufbau aufweist und eine Schalteinrichtung bildet.

6. Halbleitereinrichtung nach Anspruch 1 oder 2, wobei in dem Siliciumbereich mindestens ein Transistor mit statischer Induktion ausgebildet ist.

7. Halbleitereinrichtung nach Anspruch 1 oder 2, wobei in dem Siliciumbereich (57...59; 64, 65) mindestens ein Junction-Feldeffekttransistor ausgebildet ist.

8. Halbleitereinrichtung nach Anspruch 1 oder 2, wobei in dem Siliciumbereich mindestens ein Transistor mit permeabler Basis ausgebildet ist.

**Revendications**

1. Dispositif à semiconducteurs comportant
un substrat isolant (11),
une couche (12) réalisée en un matériau fournissant une conduction métallique et déposé sur le substrat (11), et
une région en silicium (13, 14) obtenue par croissance sur ladite couche (12),
et dans lequel une région active du dispositif à semiconducteurs est formée dans ladite région en silicium (13, 14), et ladite couche (12) est utilisée en tant qu'électrode du dispositif à semiconducteurs,
caractérisé en ce que ladite couche (12) est constituée par un siliciure d'un métal de transition, qui est formé par croissance hétéro-épitaxiale sur le substrat (11), et sur cette couche ladite région en silicium (13, 14) est formée par croissance hétéro-épitaxiale.

2. Dispositif à semiconducteurs selon la revendication 1, dans lequel le substrat (11) est constitué par un saphir ou un spinelle.

3. Dispositif à semiconducteurs selon la revendication 1 ou 2, dans lequel ladite région en silicium (42...44) possède au moins une structure pnp (ou npn) et constitue un transistor bipolaire.

4. Dispositif à semiconducteurs selon la revendication 1 ou 2, dans lequel ladite région en silicium possède au moins une structure pin ou pnin (ou npin).

5. Dispositif à semiconducteurs selon la revendication 1 ou 2, dans lequel ladite région en silicium (49...52) possède au moins une structure pnpn et constitue un dispositif de commutation.

6. Dispositif à semiconducteur selon la revendication 1 ou 2, dans lequel au moins un transistor à induction statique est formé dans ladite région en silicium.

7. Dispositif à semiconducteurs selon la revendication 1 ou 2, dans lequel au moins un transistor à effet de champ à jonction est formé dans ladite région en silicium (57...59; 64, 65).

8. Dispositif à semiconducteurs selon la revendication 1 ou 2, dans lequel au moins un transistor à base perméable est formé dans ladite région en silicium.

## FIG. 1

## FIG. 4

FIG. 2a

FIG. 2b

FIG. 2c

FIG. 2d

FIG. 3

FIG. 5

FIG. 6

FIG. 7

FIG. 8